# EUROPÄISCHE PATENTSCHRIFT

(11) **EP 3 340 746 B1**
(45) Veröffentlichungstag und Bekanntmachung des Hinweises auf die Patenterteilung: **05.05.2021**
(21) Anmeldenummer: 16206223.6
(22) Anmeldetag: 22.12.2016
(51) Int. Cl.: H05H 1/24, H05H 1/46, F03H 1/00, H01J 37/32

(54) **STEUERUNGSEINHEIT ZUR STEUERUNG EINES HOCHFREQUENZGENERATORS**
CONTROL UNIT FOR CONTROLLING A HIGH FREQUENCY GENERATOR
UNITÉ DE COMMANDE D'UN GÉNÉRATEUR HAUTE FRÉQUENCE

(43) Veröffentlichungstag der Anmeldung: 27.06.2018
(73) Patentinhaber: Technische Hochschule Mittelhessen, 35390 Giessen (DE)
(72) Erfinder: Simon, Jens, 35232 Dautphetal (DE); Probst, Uwe, 35625 Hüttenberg (DE)
(74) Vertreter: Stumpf, Peter

(56) Entgegenhaltungen:
- US-A1- 2002 144 983
- US-A1- 2006 232 471
- US-A1- 2009 058 303
- US-A1- 2016 111 259

## Beschreibung

### Steuerungseinheit zur Steuerung eines Hochfrequenzgenerators

Die Erfindung betrifft eine Steuerungseinheit zur Steuerung eines Hochfrequenzgenerators, wie er insbesondere zur Einkopplung von lonisationsenergie in eine induktiv oder induktiv-kapazitiv angeregte lonen- oder Elektronenquelle verwendet wird.

### Beschreibung und Einleitung des allgemeinen Gebietes der Erfindung

Zum Betrieb eines Ionentriebwerks ist der Hochfrequenzgenerator dazu erforderlich, um typischerweise über eine Entladungsspule ein induktiv-gekoppeltes Niedertemperaturplasma zu heizen. Hochfrequenzgeneratoren werden üblicherweise auch als Radiofrequenzgeneratoren bezeichnet und mit RFG abgekürzt.

In der Elektrotechnik ist der Frequenzbereich von 9 kHz bis zum langwelligen Licht (ab ca. 1THz) als Hochfrequenz bezeichnet.

Hochfrequenzangeregte lonen- und Elektronenquellen dienen unter anderem als hocheffiziente elektrische Antriebe in der Raumfahrt. Diese Antriebe werden in diesem Zusammenhang auch als (Radiofrequenz-)lonentriebwerke bezeichnet. Eine übliche Abkürzung für diese Art von Triebwerken ist RIT. Sie kommen weiterhin in der Materialbearbeitung - beispielsweise zur Reinigung von Oberflächen - sowie zur Heizung von Fusionsplasmen zum Einsatz.

Bei einem Ionentriebwerk beispielsweise befindet sich ein hochfrequent anzuregendes Plasma innerhalb eines isolierten Gefäßes, des sog. Entladungsgefäßes. Um das Entladungsgefäß ist eine Koppelspule zur Einspeisung einer zur Plasmaanregung notwendigen Hochfrequenz-Energie gewickelt, Das Plasma befindet sich damit innerhalb der Koppelspule, Diese bildet gemeinsam mit einem externen Koppelkondensator einen Schwingkreis bzw. Resonanzkreis, wobei die Hochfrequenz-Energie über diesen Resonanzkreis eingekoppelt wird. Kommt es durch Zustandsänderungen z. B. Änderungen der Dichte oder Leitfähigkeit des Plasmas zu Impedanzänderungen, so bewirken diese Verstimmungen des Resonanzkreises.

Aus dem Plasma werden Ionen extrahiert und durch elektrostatische Felder auf sehr hohe Geschwindigkeiten beschleunigt, wodurch in der Anwendung als RIT Schub erzeugt wird. Der Schub kann zum einen über die Menge des dem Plasma zugeführten Neutralgases (Treibstoff) und zum anderen über die durch den Hochfrequenzgenerator in das Plasma eingekoppelte elektrische Hochfrequenzleistung variiert werden. Die Anpassung der Treibstoffmenge erfolgt auf vergleichsweise großen Zeitskalen (einige Sekunden) und wird typischerweise für große Schubänderungen genutzt. Kleinere Schubanpassungen werden über die Variation der durch den RFG zugeführten elektrischen Leistung vorgenommen.

Um in jedem Arbeitspunkt des Plasmas einen möglichst effizienten Betrieb der Hochfrequenzerzeugung und -einkopplung in das Plasma zu gewährleisten, ist zudem eine kontinuierliche Abstimmung des Hochfrequenzgenerators auf die veränderlichen Plasma-Lastbedingungen erforderlich. Darüber hinaus benötigt jeder Triebwerkstyp eine eigene Hochfrequenzgenerator-Konfiguration (Ausgangsleistung und -frequenz).

### Stand der Technik

Bisher für (Radiofrequenz-)lonentriebwerke verwendete Hochfrequenzgeneratoren geben entweder eine konstante Frequenz (z. B.13, 56 MHz) aus oder nutzen Regelungskonzepte auf Basis von Phasenregelschleifen (PLL) mit spannungsgesteuerten Oszillatoren (VCO) zur Anpassung der Ausgangsfrequenz auf die aktuell vorherrschenden Lastbedingungen. Dies ist beispielsweise in den Schriften DE 10 2007 036 592 B4 und US 2009/058303 A1 der Fall. Als Leistungsstufe kommt typischerweise ein Halb- oder Vollbrückenwechselrichter mit Feldeffekttransistoren zum Einsatz. Der Wechselrichter versorgt einen elektrischen Schwingkreis, im einfachsten Fall bestehend aus der Resonanzkapazität (Koppelkondensator) und der Entladungsspule (Koppelspule) des Triebwerks, mit einem hochfrequenten Wechselstrom. Die Impedanz des Schwingkreises - und damit auch seine Resonanzfrequenz - ändern sich für unterschiedliche Arbeitspunkte des Plasmas. Um die von der Entladungsspule in das Plasma eingekoppelte elektrische Leistung zu maximieren, muss der Schwingkreis zu jedem Zeitpunkt mit seiner Resonanzfrequenz betrieben werden. Zu diesem Zweck wird die Phasenlage des sinusförmigen Stromes im Schwingkreis gemessen und mit der Spannung an der Leistungsstufe verglichen. Die Phasendifferenz muss durch eine entsprechende Stelleinrichtung zu Null geregelt werden, um so den Resonanzbetrieb sicherzustellen.

Bei Hochfrequenzgeneratoren mit konstanter Ausgangsfrequenz kommt zur Impedanzanpassung eine mechanische Baueinheit zum Einsatz, welche die Kapazität eines oder mehrerer Kondensatoren z. B. durch Oberflächenveränderung oder die Induktivität einer Spule z. B. durch Einfahren eines Eisenkernes (oder eines Ferrits) variiert. Diese Bauteile bilden ein Impedanzanpassungsnetzwerk. Dieses Bauelement wird auch als sogenannte Matchbox bezeichnet. Diese Matchbox wird in den Schwingkreis integriert, wodurch die Resonanzfrequenz des Lastkreises auf die konstante Ausgangsfrequenz der Leistungsstufe des Hochfrequenzgenerators abgestimmt werden kann. Bei Hochfrequenzgeneratoren mit Phasenregelschleife wird hingegen die Oszillationsfrequenz eines VCOs so angepasst, dass die Halbleiterbauelemente in der Leistungsstufe mit der Resonanzfrequenz des Schwingkreises geschaltet werden.

Die Druckschrift DE 199 48 229 C1 offenbart eine Hochfrequenzionenquelle mit einem Hochfrequenzgenerator, der mit einem PLL-Regelkreis ausgestattet ist, und mit einer Hochfrequenzspule, wobei die Hochfrequenzspule mit einem Kondensator einen Serien- oder Parallel-Resonanzkreis bildet.

Hochfrequenzgeneratoren mit PLL-Regelschaltung können die Ausgangsfrequenz schneller (je nach Auslegung < 100 Mikrosekunden) auf veränderliche Plasma-Lastbedingungen anpassen und erfordern keine Matchbox, wodurch die durch Fehlanpassung entstehenden Verluste verringert werden.

Allerdings bieten beide Ansätze keine Möglichkeit, die abgegebene Leistung hochdynamisch zu variieren, um so Einfluss auf den vom Triebwerk erzeugten Schub zu nehmen. Die in das Plasma eingekoppelte Leistung wird hier typischerweise durch Variation der Hochfrequenzgenerator-Eingangsgleichspannung gesteuert. Dieser Stelleingriff ist allerdings relativ träge, da zunächst die Zwischenkreiskapazitäten des Hochfrequenzgenerators auf die neue Eingangsspannung umgeladen werden müssen. Aus diesem Grund erlauben die bestehenden Hochfrequenzgenerator-Konzepte keine spontane Variation der in das Plasma eingekoppelten Hochfrequenzleistung.

Für die Anwendung in Verbindung mit Radiofrequenz-Ionentriebwerken bedeutet dies, dass eine Schubanpassung durch Variation der Hochfrequenzleistung immer eine gewisse Dauer in Anspruch nimmt und nicht instantan erfolgen kann. Die schnelle (einige zehn Mikrosekunden) Variation des vom Triebwerk erzeugten Schubes ist aber vor allem für Raumfahrtmissionen mit hochgenauen Lageregelungsanforderungen interessant. RFG-Konzepte, welche eine schnelle Anpassung der Ausgangsleistung bieten, sind somit potentiell in der Lage, den Radiofrequenz-Ionentriebwerken ein neues Anwendungsfeld im Bereich der Raumfahrtantriebe zu eröffnen. Darüber hinaus ist u. U. auch eine vorteilhafte Nutzung der hochdynamischen Leistungsregelung in terrestrischen Anwendungen denkbar.

### Aufgabe

Aufgabe der Erfindung ist es eine Steuerung für einen Hochfrequenzgenerator mit weitem Frequenz- und Leistungsbereich bereitzustellen, welche die Effizienz der Hochfrequenzerzeugung und -übertragung durch eine schnelle und zuverlässige Steuerung von Leistung und Frequenz erhöht.

### Lösung der Aufgabe

Gelöst wird diese Aufgabe durch eine Vorrichtung mit den Merkmalen des Anspruchs 1. Vorteilhafte Ausführungsformen und Weiterbildungen der vorliegenden Erfindung ergeben sich aus den Unteransprüchen.

Zur Einordnung der Steuerung in den Kontext des zu steuernden Hochfrequenzgenerators wird im Folgenden beispielhaft näher erläutert, wie ein Hochfrequenzgenerator 1 mit seinen Baugruppen aufgebaut ist.

Eine erste Baugruppe des Hochfrequenzgenerators 1 ist der Eingangs- und Brückenfilter 10, welcher mit einer Gleichstromquelle 2 (U= 0 bis 1000V) zur Energiebereitstellung verbindbar ist. Diese Baugruppe dient zum Abblocken von Oberschwingungen, welche bei der Hochfrequenz-Erzeugung mit schaltenden Umrichtern unweigerlich entstehen. Der Eingangs- und Brückenfilter ist üblicherweise als Tiefpass ausgebildet. Er dient zugleich der Stabilisierung der Brückenspannung im Schaltbetrieb.

Eine zweite Baugruppe ist Leistungsstufe 20. Diese umfasst die beiden als Leistungsschalter ausgeführten Schalter T+ und T-. Diese Schalter wirken wie Ventile und bestimmen Leistung und Frequenz des Hochfrequenzgenerators. Diese sind bevorzugt als Leistungs-MOSFETs in Halbbrückenkonfiguration ausgeführt. Andere Feldeffekttransistoren wie IGBTs sind grundsätzlich möglich, weisen aber höhere Schaltzeiten als MOSFETs auf, weshalb sie üblicherweise nicht verwendet werden.

Eine dritte Baugruppe bildet der Resonanzkreis 30. Dieser dient zu Energieabgabe des Hochfrequenzgenerators 1 an eine Last 3. Die Last 3 kann beispielsweise eine induktiv geheizte lonen- oder Elektronenquelle sein. Um den Generator auf unterschiedliche Resonanzfrequenzen und induktive Lastkomponenten anpassen zu können, wird die Resonanzkapazität separat realisiert. So kann der Generator durch Austauschen von Bauteilen wie Kapazitäten (z.B. Kondensatoren) oder Induktivitäten (z.B. Spulen) auf die gewünschte Ausgangsfrequenz und verwendete Triebwerkslast abgestimmt werden. Darüber hinaus kann der Resonanzkreis 30 im Generator zu einem Impedanzanpassungsnetzwerk erweitert werden.

Da die Resonanzkapazitäten im Lastkreis liegen, muss deren Anbindung auf maximale Ausgangsspannung und maximalen -strom ausgelegt werden. Dies ist insbesondere durch die dämpfungsabhängige Resonanzüberhöhung der Ausgangsgrößen kritisch.

Die Steuerungseinheit 40 bildet die vierte Baugruppe. Sie dient dazu festzulegen, wann die beiden Schalter T+ und T- der Leistungsstufe geschaltet werden.

Die erfindungsgemäße Steuerungseinheit 40 umfasst dabei wenigstens *i*) Eine Treiberstufe 410, welche so ausgebildet ist, dass sie die Schalter T+ und T-einer Leistungsstufe 20 eines Hochfrequenzgenerators 1 ansteuern kann. Um sowohl den unterresonanten als auch den überresonanten Betrieb zu ermöglichen, wird die Ansteuerung der beiden Schalter bevorzugt selbstgeführt realisiert. Selbstgeführt heißt dass sowohl der Einschalt- als auch der Ausschaltzeitpunkt der Schalter kann frei bestimmt werden. - im Gegensatz zum fremd- oder netzgeführten Wechselrichter. So kann sowohl der unterresonante Schalter schalten nach dem jeweiligen Stromnulldurchgang ein) als auch der überresonante (Schalter schalten vor dem jeweiligen Stromnulldurchgang ein Betrieb genutzt werden.

Jeder der beiden Schalter benötigt einen Treiber, wobei der erste Schalter T+ einen High-Side Schalter darstellt, dessen Bezugspotential je nach Schaltzustand floatet. Damit T+ sicher durchschalten kann, muss das Ansteuersignal dasselbe Bezugspotential aufweisen. Daher wird die Treiberstufe 410 mit einer galvanischen Trennung und separaten Versorgungsspannungen für die Schalter T+ und T- aufgebaut.

Ergänzend zu den bauartbedingten Inversdioden der verwendeten Leistungsschalter werden in einer alternativen Ausführungsform externe Freilaufdioden mit niedriger Reverse-Recovery-Ladung Qrr parallel zu den Schaltern geschaltet. Dies dient zur Verringerung der zusätzlichen Schaltverluste durch die Diodenrückstromspitzen im unterresonanten Betrieb.

Weiterhin umfasst die erfindungsgemäße Steuerungseinheit 40 dabei wenigstens
ii) Eine Steuerung 430, welche so ausgebildet ist, dass sie ein Steuersignal zur Ansteuerung einer Leistungsstufe (20) erzeugen kann. Um die Steuerung des Generators ebenso flexibel wie die Abstimmung des Resonanzkreises 30 handhaben zu können, ist diese vorzugsweise separat realisiert. Durch eine universelle Schnittstelle, an die alle zur Steuerung des Generators relevanten Signale herangeführt werden, können alternative Steuerungsplattformen, falls dies durch Änderungen im Regelalgorithmus erforderlich wird, zum Einsatz kommen.

Zusätzlich umfasst die erfindungsgemäße Steuerungseinheit 40 dabei wenigstens
iii) Ein Stromsensor 440 zur Messung des Sekundärstroms Is im Resonanzkreis 30 des Hochfrequenzüberträgers des Hochfrequenzgenerators 1 und zur Übergabe dieser Messdaten an die Steuerung 430. Hierbei wirken der Stromsensor 440 und die Steuerung 430 so zusammen, dass die Messdaten des Sekundärstroms Is durch die Steuerung 430 in ein Steuersignal zur Regelung der Treiberstufe 410 umgesetzt werden können.

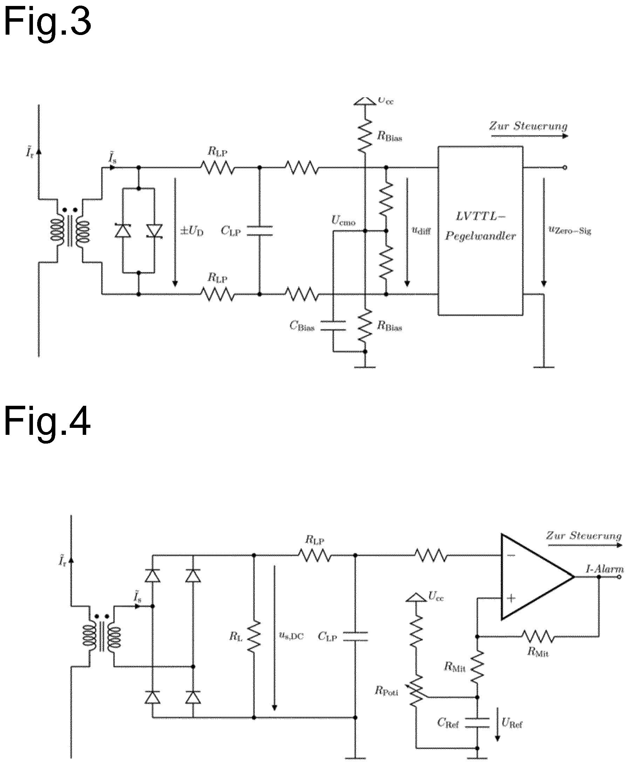

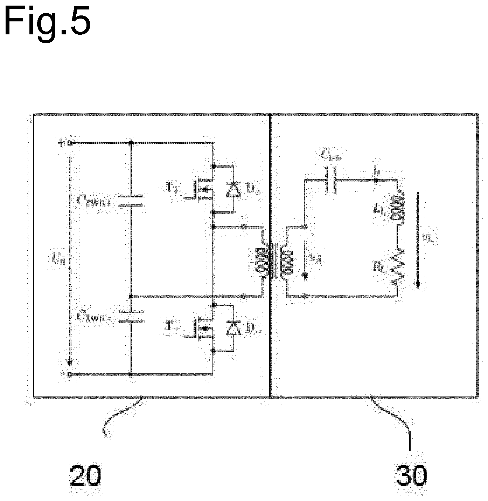

Der Stromsensor 440 ist in der Ausführungsform der erfindungsgemäßen Steuerungseinheit 40 als Messwandler zur Stromnulldurchgangserkennung (wie in Fig.3 gezeigt) ausgeführt. Dieser ist so ausgebildet, dass er zwei antiparallel geschaltete Dioden aufweist über welche der Sekundärstrom eines Hochfrequenzüberträgers des Hochfrequenzgenerators geleitet werden kann. Diese sind vorzugsweise als Schottky-Dioden ausgebildet. Diese Dioden sind so angeordnet, dass abhängig von der Phasenlage des Primärstroms, der Sekundärstrom über eine der beiden Dioden fließen und dort einen Spannungsabfall in Höhe der Diodenflussspannung U_{D} hervorrufen kann. Die Dioden sind weiterhin so angeordnet, dass das Vorzeichen der Spannung, abhängig davon, welche Diode gerade leitet, variieren kann. Das führt zu einem nahezu rechteckförmigen Signalverlauf an den Dioden, der sich leicht hinsichtlich des Stromnulldurchgangs auswerten lässt. Weiterhin umfasst der Stromsensor einen Tiefpassfilter zur Filterung des differentiellen Spannungsmesssignals. Dieser dient dazu, hochfrequente elektromagnetische Störungen, wie sie durch Schaltvorgänge im Leistungsteil auftreten können, zu minimieren. Vorzugsweise umfasst der Stromsensor noch wenigstens einen nachgeschalteten elektrischen Widerstand. Über diesen Widerstand wird ein hochohmiger Abschluss des Tiefpassfilters sichergestellt. Weiterhin umfasst der Stromsensor 430 noch einen Pegelwandler, zur Umwandlung eines differentiellen Messsignals U_{diff} in ein Low- Voltage- TTL-Signal, wobei das Low- Voltage- TTL-Signal von der Steuerung akzeptiert werden kann. Dieser ist so ausgebildet, dass er das differentielle Messsignal auf einen definierten Pegel gegenüber Masse legen kann.

In einer zweiten Ausführungsform umfasst die erfindungsgemäße Steuerungs-einheit 40 weiterhin ein Bedien- und Kontrollterminal 420 umfassend wenigstens ein Eingabemittel 421 zur Eingabe von Steuerinformationen. Das kann z.B. ein oder mehrere Kippschalter sein. Weiterhin umfasst das Bedien- und Kontrollterminal ein Auswertemittel 422 zur Auswertung der Informationen des Eingabemittels zur Weitergabe der Bedien- und Kontrollterminaldaten an eine Steuerung 430 sowie zur Verarbeitung der Signale aus der Steuerung 430 zur Wiedergabe mit dem mindestens einen Ausgabemittel. Weiterhin umfasst das Bedien- und Kontrollterminal wenigstens ein Ausgabemittel 423. Dieses kann z.B. Oszillogramme und/oder LEDs umfassen und dient zur Ausgabe von Ausgabeinformationen Das Bedien- und Kontrollterminal ist dabei mit der Steuerung 430 verbunden. Die Parametrisierung der Steuerung 430 erfolgt durch Logiksignale, die mit dem Eingabemittel erzeugt werden können. Anhand von in der Steuerung 430 generierten Ausgabesignalen, welche über das Ausgabemittel 423 ausgegeben (z.B. visuell oder akustisch) werden, kann die ordnungsgemäße Funktion der Hochfrequenz-erzeugung überprüft bzw. der Grund einer Fehlfunktion ermittelt werden.

In einer dritten Ausführungsform umfasst die erfindungsgemäße Steuerungseinheit 40 weiterhin eine Temperaturüberwachung, um im Fehlerfall eine thermische Zerstörung der Leistungsstufe 20 zu verhindern.

Die Temperaturüberwachung ist dabei so angeordnet, dass sie die Temperatur eines Hochfrequenzgenerators 1 messen und das Temperatursignal an die Steuerung 430 übermitteln kann. Sie umfasst dabei eine Temperaturmesseinheit wie z.B. ein Widerstandsthermometer und ein Übertragungsmittel zur Übertragung der Temperaturinformation an die Steuerung. Übersteigt die Temperatur einen vordefinierten Grenzwert, werden die Leistungsschalter softwaretechnisch gesperrt. Weiterhin ist die Temperaturüberwachung bevorzugt dazu geeignet, bereits die Überschreitung einer niedrigeren Temperaturgrenze an die Steuerung zu melden, um rechtzeitig geeignete Kühlungsmaßnahmen einleiten zu können.

In einer vierten Ausführungsform umfasst die erfindungsgemäße Steuerungseinheit 40 eine Temperaturüberwachung welche ihrerseits noch eine Lüfteransteuerung umfasst. Diese ist so ausgebildet, dass sie in Abhängigkeit Temperatur-signals der Temperaturüberwachung einen Lüfter ansteuern kann. Damit kann sie in Abhängigkeit von der Temperatur noch aktive Kühlmaßnahmen einleiten.

In einer fünften Ausführungsform umfasst die die erfindungsgemäße Steuerungseinheit 40 weiterhin eine Stromamplitudenüberwachung, welche so angeordnet ist, dass sie ein Stromamplitudensignal an die Steuerung 430 übermitteln kann. Dies dient dazu, um im Kurzschluss- bzw. Überlastungsfall eine Zerstörung der Bauelemente des Hochfrequenzgenerators verhindern zu können. Auch dieser Stromsensor enthält einen Hochfrequenzüberträger, um die galvanische Trennung zum Leistungsteil sicherzustellen. Sekundärseitig speist der Hochfrequenzüberträger des Resonanzkreises 30 einen Diodengleichrichter, der mit dem Widerstand R_{L} abgeschlossen ist. Das gleichgerichtete Spannungssignal Us, wird zur Glättung tiefpassgefiltert und über einen Komparator mit einer Referenzspannung Uref verglichen. Liegt ein Überlastungsfall vor, so überschreitet das Messsignal die Referenzspannung und der Komparator löst Alarm aus. Die Höhe der Referenzspannung bzw. der zulässige Primärstrom Ir im Leistungskreis, kann über ein Potentiometer angepasst werden. Ein Kondensator kann zur Stabilisierung der Referenzspannung eingesetzt werden. Um im Überlastungsfall ein stabiles Schaltverhalten des Komparators sicherzustellen, ist dieser über elektrische Widerstände gekoppelt.

Hierbei ist es auch möglich die einzelnen Ausführungsformen zu kombinieren. Sowohl das Bedien- und Kontrollterminal 420 die Temperaturüberwachung und die Stromamplitudenüberwachung sind einzeln und in Kombination implementierbar. Für jede dieser Kombinationen ist auch möglich den Stromsensor 440 als Messwandler zur Stromnulldurchgangserkennung auszuführen.

Um die in eine Last 3 (z.B. ein Plasma) eingekoppelte Leistung zu maximieren, ist die Steuerung Hochfrequenzgenerators so ausgebildet, dass eine kontinuierliche Abstimmung auf veränderliche Entladungsbedingungen erfolgt. Die Ansteuersignale der Leistungsschalter werden durch die die Steuerung 430 der erfindungsgemäßen Steuerungseinheit 40 zur Frequenz- und Phasenregelung generiert. Durch das Nachführen der Schaltfrequenz auf die Frequenz und die Phasenlage des Laststromes über die erfindungsgemäße Steuerungseinheit 40 kann die Hochfrequenzerzeugung im laufendem Betrieb innerhalb weniger Schwingungsperioden auf veränderte Lastbedingungen (z.B. in einem Plasma) eingestellt werden. Dadurch werden die, bei der Hochfrequenzerzeugung dominanten, Schaltverluste im Generator nahezu eliminiert.

Damit wird der Wechselrichter (als Teil des Hochfrequenzgenerators) ständig im effizientesten Arbeitspunkt betrieben und bei Nutzung geeigneter Kühlungsmaßnahmen sind Ausgangsleistungen bis in den einstelligen Kilowatt-Bereich möglich. Damit findet - entgegen gängiger Steuerungseinheiten für Hochfrequenzanwendungen, welche typischerweise auf analoger Schaltungstechnik beruhen - eine digitale Implementierung der Steuerung Anwendung, wodurch eine zuverlässige Versorgung der induktiv-gekoppelten Entladung gewährleistet werden kann.

Darüber hinaus bietet die erfindungsgemäße Steuerungseinheit in Verbindung mit der digitalen Implementierung die Möglichkeit, durch das Auslassen von Leitdauern die Ausgangsleistung ohne Wirkungsgradverringerung hochdynamisch zu variieren. So kann der aus der Ionen- oder Elektronenquelle extrahierte Ladungsträgerfluss sehr schnell (innerhalb einiger zehn Mikrosekunden) variiert werden.

Für die Anwendung in Ionentriebwerken bedeutet dies, dass der vom Triebwerk erzeugte Schub hochdynamisch angepasst werden kann, ohne auf die äußerst träge Änderung der in das Entladungsgefäß eingelassenen Treibstoffmenge oder die Anpassung der Eingangsgleichspannung des Hochfrequenzgenerators angewiesen zu sein. Diese Fähigkeit ist vor allem interessant für Raumfahrtmissionen mit hochgenauen Lageregelungsanforderungen, bei denen ein Raumflugkörper durch geringe und äußerst schnell veränderliche Schübe von Steuertriebwerken in einer bestimmten Position gehalten werden soll.

Insgesamt stellt die erfindungsgemäße Steuerungseinheit 40 Erfindung eine Steuerung für einen Hochfrequenzgenerator mit weitem Frequenz- und Leistungsbereich bereit. Diese erhöht die Effizienz durch eine schnelle und zuverlässige Steuerung der Frequenz und ermöglicht die hochdynamische Variation der abgegebenen Hochfrequenzleistung in einigen zehn Mikrosekunden, ohne dabei die Effizienz der zu Hochfrequenzerzeugung und -übertragung negativ zu beeinflussen.

### Abbildungen

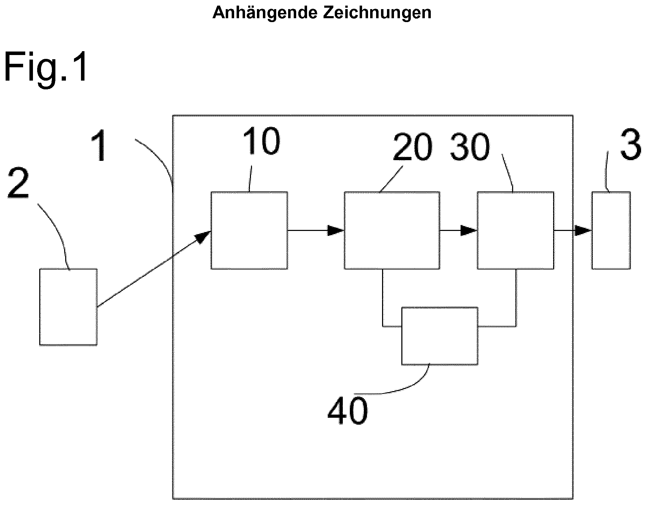

Fig. 1 schematischer Aufbau eines Hochfrequenzgenerators 1 Die Pfeilrichtungen zeigen hier die Richtung der Leistungsübertragung an.

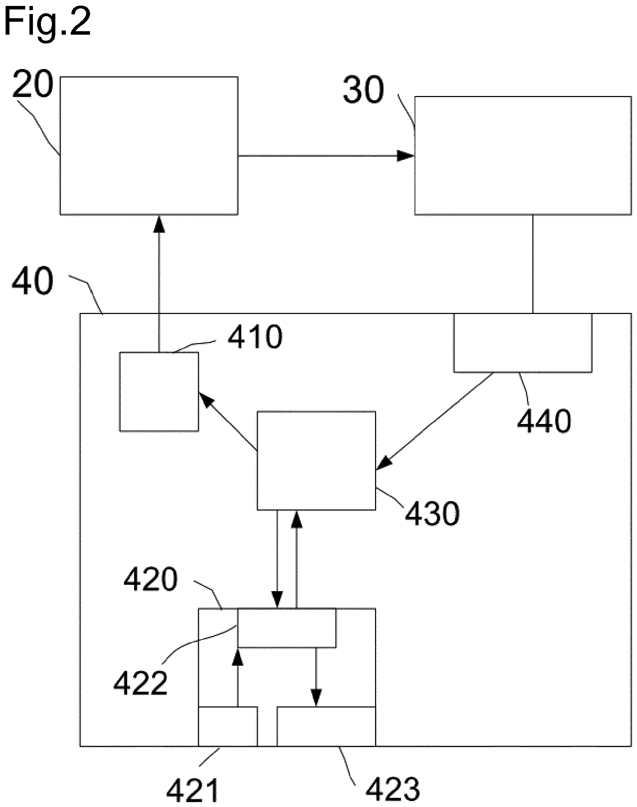

Fig. 2 schematischer Aufbau einer erfindungsgemäßen Steuerungseinheit 40 mit einem Bedien- und Kontrollterminal 420
Die Pfeilrichtungen zeigen hier die Richtung der Datenübertragung an.
Fig. 3 Aufbau des beispielhaften Stromsensors 440 in Form eines Messwandlers zur Stromnulldurchgangserkennung
Fig. 4 Aufbau eines beispielhaften Stromsensors in Form eines Messwandlers zur Stromamplitudenüberwachung
Fig.4. Aufbau der Leistungsstufe sowie des Resonanzkreises

### Bezugszeichenliste

1 Hochfrequenzgenerator
2 Gleichstromquelle
3 Last
10 Eingangs- und Brückenfilter
20 Leistungsstufe
30 Resonanzkreis
40 Steuerungseinheit
410 Treiberstufe
420 Bedien- und Kontrollterminal
421 Eingabemittel
422 Auswertemittel
423 Ausgabemittel
430 Steuerung
440 Stromsensor

## Patentansprüche

1. Steuerungseinheit (40) zur Steuerung eines Hochfrequenzgenerators (1), wobei dieser einen Resonanzkreis (30) als Hochfrequenzüberträger umfasst, umfassend wenigstens folgende Bauelemente:
i. eine Treiberstufe (410) ausgebildet für die Steuerung von Schalter (T+) und (T-) einer Leistungsstufe (20) eines Hochfrequenzgenerators
ii. eine Steuerung (430) ausgebildet für die Erzeugung eines Steuersignals zur Ansteuerung der Treiberstufe (410), wobei die Steuerungseinheit (40) weiterhin einen Stromsensor (440) zur Messung des Sekundärstroms Isim Resonanzkreis (30) des Hochfrequenzüberträgers des Hochfrequenzgenerators (1) und zur Übergabe dieser Messdaten des Sekundärstroms Isan die Steuerung (430) umfasst, wobei der Stromsensor (440) und die Steuerung (430) so zusammenwirken, dass die Messdaten des Sekundärstroms Isdurch die Steuerung (430) in ein Steuersignal zur Regelung der Treiberstufe (410) umsetzbar sind, wobei der Stromsensor (440) als Messwandler zur Stromnulldurchgangserkennung ausgebildet ist, **dadurch gekennzeichnet, dass** der Stromsensor (440) zwei antiparallel geschaltete Dioden aufweist über welche der Sekundärstrom eines Hochfrequenzüberträgers des Hochfrequenzgenerators leitbar ist

2. Steuerungseinheit (40) gemäß Anspruch 1 **dadurch gekennzeichnet, dass** diese weiterhin ein Bedien- und Kontrollterminal (420) mit wenigstens einem Eingabemittel (421) zur Eingabe von Steuerinformationen, mit wenigstens einem Auswertemittel (422) zur Auswertung der Informationen des Eingabemittels zur Weitergabe der Steuerinformationen an die Steuerung (430) sowie zur Verarbeitung der Signale aus einer Steuerung (430) zur Wiedergabe mit mindestens einem Ausgabemittel (423) und wenigstens mit einem Ausgabemittel (423) zur Ausgabe von Ausgabeinformationen umfasst.

3. Steuerungseinheit (40) gemäß Anspruch 1 oder 2 **dadurch gekennzeichnet, dass** diese weiterhin wenigstens eine Temperaturüberwachung umfasst, welche für die Messung der Temperatur des Hochfrequenzgenerators (1) und für die Übermitteilung des Temperatursignal an die Steuerung (430) angeordnet ist.

4. Steuerungseinheit (40) gemäß Anspruch 3 **dadurch gekennzeichnet, dass** die Temperaturüberwachung weiterhin noch eine Lüfteransteuerung umfasst, welche für die Ansteuerung in Abhängigkeit ihres Temperatursignals eines Lüfter ausgebildet ist.

5. Steuerungseinheit (40) gemäß einem der früheren Ansprüche **dadurch gekennzeichnet. dass** sie eine Stromamplitudenüberwachung umfasst, welche für die Messung der Stromamplitude des Hochfrequenzgenerators (1) und für die Übermitteilung eines Stromamplitudensignals an die Steuerung (430) angeordnet ist.

6. Hochfrequenzgenerator (1), **dadurch gekennzeichnet, dass** dieser eine Steuerungseinheit (40) gemäß einem der Ansprüche 1 bis 5 umfasst.

7. Ionentriebwerk, **dadurch gekennzeichnet, dass** es einen Hochfrequenzgenerator (1) gemäß Anspruch 6 mit einer Steuerungseinheit (40) gemäß einem der Ansprüche 1 bis 5 umfasst

## Claims

1. Control unit (40) for controlling a high-frequency generator (1), the latter comprising a resonant circuit (30) as a high-frequency transmitter, comprising at least the following components:
i. a driver stage (410) designed for controlling switches (T+) and (T-) of a power stage (20) of a high-frequency generator (1)
ii. a control unit (430) for generating a control signal for driving the driver stage (410)
wherein the control unit (40) further comprises a current sensor (440) for measuring the secondary current Is in the resonant circuit (30) of the high-frequency transformer of the high-frequency generator (1) and for transmitting this measurement data of the secondary current Is to the control unit (430), the current sensor (440) and the control unit (430) cooperating in such a manner that the measurement data of the secondary current Is can be converted by the controller (430) into a control signal for regulating the driver stage (410), the current sensor (440) being designed as a measurement transformer for current zero-crossing detection, **characterized in that** the current sensor (440) has two antiparallel-connected diodes via which the secondary current of a high-frequency transformer of the high-frequency generator can be conducted.

2. Control unit (40) according to claim 1, **characterized in that** it further comprises an operating and control terminal (420) with at least one input means (421) for inputting control information, with at least one evaluation means (422) for evaluating the information of the input means for passing on the control information to the controller (430) and for processing the signals from a controller (430) for reproduction with at least one output means (423) and at least one output means (423) for outputting output information.

3. A control unit (40) according to claim 1 or 2, **characterized in that** it further comprises at least one temperature monitor arranged for measuring the temperature of the radio frequency generator (1) and for transmitting the temperature signal to the controller (430).

4. A control unit (40) according to claim 3, **characterised in that** the temperature monitoring further comprises a fan control which is designed to control a fan in dependence on its temperature signal.

5. Control unit (40) according to any one of the preceding claims **characterised in that** it comprises a current amplitude monitor arranged to measure the current amplitude of the high frequency generator (1) and to transmit a current amplitude signal to the controller (430).

6. High-frequency generator (1), **characterized in that** it comprises a control unit (40) according to any one of claims 1 to 5.

7. Ion thruster, **characterized in that** it comprises a high frequency generator (1) according to claim 6 with a control unit (40) according to any one of claims 1 to 5.t.

## Revendications

1. Une unité de commande (40) pour commander un générateur á haute fréquence (1), ce dernier comprenant un circuit de résonnance (30) comme émetteur de haute fréquence, comprenant au moins les composants suivants:
i. un étage d'attaque (410) conçu pour commander les commutateurs (T+) et (T-) d'un étage de puissance (20) d'un générateur haute fréquence (1)
ii. une unité de commande (430) pour générer un signal de commande pour commander l'étage d'attaque (410)
oú l'unité de commande (40) comprend en outre un capteur de courant (440) pour mesurer le courant secondaire Is dans le circuit de résonnance (30) du transformateur haute fréquence du générateur haute fréquence (1) et pour transmettre ces données de mesure du courant secondaire Is à l'unité de commande (430), le capteur de courant (440) et l'unité de commande (430) interagissant de telle sorte que les données de mesure du courant secondaire Is sont transmises à l'unité de commande (430), en un signal de commande pour la régulation de l'étage d'attaque (410), le capteur de courant (440) étant conçu comme un transformateur de mesure pour la détection du passage par zéro du courant par le fait le capteur de courant (440) présente deux diodes montées en antiparallèle par lesquelles le courant secondaire d'un transformateur radiofréquence du générateur radiofréquence peut être conduit.

2. Unité de commande (40) selon la revendication 1, **caractérisée en ce qu'**elle comprend en outre un terminal de commande et d'exploitation (420) comportant au moins un moyen d'entrée (421) pour entrer des informations de commande, comportant au moins un moyen d'évaluation (422) pour évaluer les informations provenant du moyen d'entrée pour transmettre les informations de commande à la commande (430) et pour traiter les signaux d'une commande (430) pour transmettre au moins un moyen de sortie (423) et comportant au moins un moyen de sortie (423) pour sortir les informations de sortie.

3. Unité de commande (40) selon la revendication 1 ou 2, **caractérisée en ce qu'**elle comprend en outre au moins un contrôleur de température agencé pour mesurer la température du générateur haute fréquence (1) et pour transmettre le signal de température au contrôleur (430).

4. Unité de commande (40) selon la revendication 3, caractérisée en ce la surveillance de la température comprend en outre une commande de ventilateur adaptée pour commander un ventilateur en fonction de son signal de température.

5. Unité de commande (40) selon l'une quelconque des revendications précédentes, **caractérisée en ce qu'**elle comprend un moniteur d'amplitude de courant agencé pour mesurer l'amplitude de courant du générateur haute fréquence (1) et pour transmettre un signal d'amplitude de courant au contrôleur (430).

6. Générateur haute fréquence (1), **caractérisé en ce qu'**il comprend une unité de commande (40) selon l'une quelconque des revendications 1 à 5.

7. Propulseur ionique, **caractérisé en ce qu'**il comprend un générateur haute fréquence (1) selon la revendication 6 avec une unité de commande (40) selon l'une quelconque des revendications 1 à 5.
